# EUROPEAN PATENT APPLICATION

(11) **EP 4 693 344 A1**
(43) Date of publication of application: **11.02.2026**
(21) Application number: 24780463.6
(22) Date of filing: 27.03.2024
(51) Int. Cl.: H01B 13/00, B05D 3/12, B05D 5/12, B05D 7/24, H01B 1/22, H05K 1/09, H05K 3/12, H05K 9/00

(54) **METHOD FOR PRODUCING CONDUCTIVE BASE MATERIAL, METHOD FOR PRODUCING ELECTRONIC DEVICE, METHOD FOR PRODUCING ELECTROMAGNETIC SHIELD FILM, METHOD FOR PRODUCING SHEET-LIKE HEATING ELEMENT AND CONDUCTIVE COMPOSITION**

(30) Priority: 30.03.2023 JP 2023054831
(71) Applicant: SATO Corporation, Tokyo 108-0023 (JP)
(72) Inventor: OGAWA, Takayuki, Tokyo 108-0023 (JP); SHIBATA, Takeshi, Tokyo 108-0023 (JP)
(74) Representative: Grünecker Patent- und Rechtsanwälte PartG mbB
(86) International application number: PCT/JP2024/012270
(87) International publication number: WO 2024/204361

(57) **Abstract**

In a method for producing a conductive base material, the method including: a film formation step of providing a film formed of a conductive composition over a base material; and a conductive film formation step of forming a conductive film by at least pressing the film, a conductive composition containing conductive particles (A) containing at least one element selected from the group consisting of copper and silver and a compound (B) that suppresses one or both of corrosion and aggregation of the conductive particles (A) is used as the conductive composition.

## Description

### TECHNICAL FIELD

The present invention relates to a method for producing a conductive base material, a method for producing an electronic device, a method for producing an electromagnetic wave shielding film, a method for producing a planar heating element, and a conductive composition.

### BACKGROUND ART

A technique is known in which a conductive base material provided with a conductive film is formed by applying a conductive composition containing conductive particles on a base material to provide a coating layer and then carrying out heating, pressing, and the like on the coating layer.

As an example, the Examples of Patent Document 1 describe applying a dispersion of silver fine particles having an average primary particle size of 7 nm in water/ethylene glycol on a PET film to form a coating film and then heating and pressing the coating film at 150°C, as well as forming a conductive layer by means of this step.

As another example, the Examples of Patent Document 2 describe spin-coating a copper fine particle dispersion liquid (copper nano-ink) having copper fine particles (copper nanoparticles) having a median diameter of approximately 40 nm, a dispersion medium, and a dispersant on a glass base material to form a coating film and then baking the coating film to form a conductive film.

As a further example, Patent Document 3 describes applying a conductive ink composition containing (A) an oxycarboxylic acid, (B) a nitrogen-containing compound, (C) copper particles, and (D) a dispersion medium on a base material to form a coating film and then treating the coating film to form a conductive layer.

### RELATED DOCUMENT

### PATENT DOCUMENT

Patent Document 1: Japanese Patent No. 6181608
Patent Document 2: Japanese Unexamined Patent Publication No. 2021-044308
Patent Document 3: Japanese Unexamined Patent Publication No. 2017-191723

### SUMMARY OF THE INVENTION

### TECHNICAL PROBLEM

When forming a conductive film using a conductive composition containing conductive particles, the specific resistance of the conductive film is preferably as small as possible. In addition, being able to produce a conductive film having a low specific resistance by a simple and not overly complicated process is more preferable.

The present invention was made in consideration of these circumstances. One of the objects of the present invention is to provide a method for producing a conductive base material capable of forming a conductive film having a low specific resistance.

### SOLUTION TO PROBLEM

The present inventors completed the inventions provided below and solved the above-described problems.

1. A method for producing a conductive base material, the method including: a film formation step of providing a film formed of a conductive composition over a base material; and a conductive film formation step of forming a conductive film by at least pressing the film, in which the conductive composition contains conductive particles (A) containing at least one element selected from the group consisting of copper and silver, and a compound (B) that suppresses one or both of corrosion and aggregation of the conductive particles (A).
2. The method for producing a conductive base material according to 1., in which the base material is flexible.
3. The method for producing a conductive base material according to 1. or 2., in which, in the conductive film formation step, the film is pressed while being heated.
4. The method for producing a conductive base material according to any one of 1. to 3., in which the compound (B) includes a ligand (B1) that is capable of coordinating to copper or silver in the conductive particles (A).
5. The method for producing a conductive base material according to 4., in which the ligand (B1) includes one or more compounds selected from the group consisting of an amine, an imine, a phosphine, an azole, and a carboxylic acid.
6. The method for producing a conductive base material according to 4. or 5., in which the ligand (B1) includes at least one selected from the group consisting of a monodentate ligand and a bidentate ligand.
7. The method for producing a conductive base material according to any one of 1. to 6., in which the compound (B) includes a reducing agent (B2).
8. The method for producing a conductive base material according to 7., in which the reducing agent (B2) includes at least any one selected from the group consisting of ascorbic acid, oxalic acid, and formic acid.
9. The method for producing a conductive base material according to any one of 1. to 8., in which the compound (B) includes a nitrile compound (B3).
10. The method for producing a conductive base material according to any one of 1. to 9., in which in a volume-based cumulative particle diameter distribution curve obtained in a case where the conductive particles (A) are subjected to particle diameter measurement by a laser diffraction scattering method, a particle diameter D₅₀ at which a cumulative frequency is 50% is 0.6 to 50 µm.
11. The method for producing a conductive base material according to any one of 1. to 10., in which an amount of binder in all non-volatile components of the conductive composition is 5% by mass or less.
12. The method for producing a conductive base material according to any one of 1. to 11., in which the conductive film formation step includes a roll press step in which the base material provided with the film is transported between two opposing rolls.
13. The method for producing a conductive base material according to 12., in which, in the roll press step, a roll of the two rolls with which the film comes into contact is not heated, or is heated to 400°C or lower.
14. The method for producing a conductive base material according to 12. or 13., in which, in the roll press step, a pressure of 10 to 150 MPa is applied to the base material provided with the film.
15. The method for producing a conductive base material according to any one of 1. to 14., in which the conductive film has a pattern structure.
16. A method for producing an electronic device, in which an electronic device is produced using the conductive base material obtained by the method for producing a conductive base material according to any one of 1. to 15.
17. The method for producing an electronic device according to 16., in which the electronic device is an RF tag.
18. A method for producing an electromagnetic wave shielding film, in which an electromagnetic wave shielding film is produced using the conductive base material obtained by the method for producing a conductive base material according to any one of 1. to 15.
19. A method for producing a planar heating element, in which a planar heating element is produced using the conductive base material obtained by the method for producing a conductive base material according to any one of 1. to 15.
20. A conductive composition that is used for application where a film is formed over a base material and a conductive film is formed by at least pressing the film and contains conductive particles, the conductive composition containing: conductive particles (A) containing at least one element selected from the group consisting of copper and silver; and a compound (B) that suppresses one or both of corrosion and aggregation of the conductive particles (A).
21. The conductive composition according to 20., in which the compound (B) includes a ligand (B1) that is capable of coordinating to copper or silver in the conductive particles (A).
22. The conductive composition according to 21., in which the ligand (B1) includes one or more compounds selected from the group consisting of an amine, an imine, a phosphine, an azole, and a carboxylic acid.
23. The conductive composition according to 21. or 22., in which the ligand (B1) includes at least one selected from the group consisting of a monodentate ligand and a bidentate ligand.
24. The conductive composition according to any one of 20. to 23., in which the compound (B) includes a reducing agent (B2).
25. The conductive composition according to 24., in which the reducing agent (B2) includes at least one selected from the group consisting of ascorbic acid, oxalic acid, and formic acid.
26. The conductive composition according to any one of 20. to 25., in which the compound (B) includes a nitrile compound (B3).
27. The conductive composition according to any one of 20. to 26., in which in a volume-based cumulative particle diameter distribution curve obtained in a case where the conductive particles (A) are subjected to particle diameter measurement by a laser diffraction scattering method, a particle diameter D₅₀ at which a cumulative frequency is 50% is 0.6 to 50 µm.
28. The conductive composition according to any one of 20. to 27., in which an amount of binder in all non-volatile components is 5% by mass or less.

### ADVANTAGEOUS EFFECTS OF INVENTION

According to the present invention, it is possible to form a conductive film having a low specific resistance.

### BRIEF DESCRIPTION OF THE DRAWINGS

[FIG. 1] A view for explaining a film formation step.
[FIG. 2] A diagram for illustrating a conductive film formation step.
[FIG. 3] A diagram for illustrating the conductive film formation step.
[FIG. 4] A diagram for illustrating the conductive film formation step.

### DESCRIPTION OF EMBODIMENTS

Hereinafter, an embodiment of the present invention will be described in detail with reference to the drawings.

In all drawings, the same constituent elements are denoted by the same reference signs, and detailed description thereof will not be repeated.

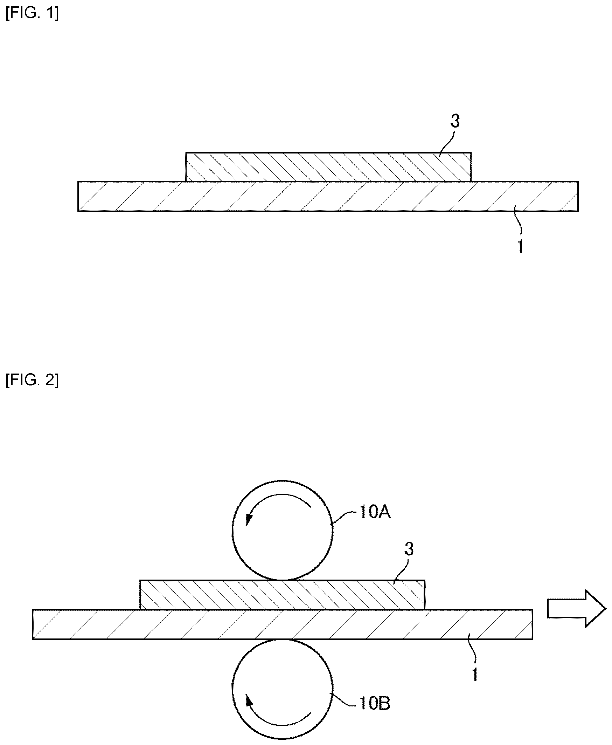

To avoid complexity, (i) when there are a plurality of identical components in the same drawing, a reference numeral may be assigned to only one thereof, and not all thereof, or (ii) particularly in FIG. 2 and subsequent figures, reference numerals may not be reassigned to the same components as in FIG. 1.

All the drawings are for illustration purposes only. The shapes, dimensional ratios, and the like of each of the members in the drawings do not necessarily correspond to the actual products.

In the present specification, the notation "X to Y" in the description of the numerical range indicates X or more and Y or less unless otherwise specified. For example, "1% to 5% by mass" means "1% by mass or more and 5% by mass or less".

### <Method for Producing Conductive Base Material>

The method for producing a conductive base material according to the present embodiment includes a film formation step of providing a film formed of a conductive composition containing conductive particles on a base material, and a conductive film formation step of forming a conductive film by pressing the film at least.

A specific explanation will be given below of each step with reference to the drawings.

### (FIG 1: Film Formation Step)

In the film formation step, a film 3 is provided by applying or printing a conductive composition containing conductive particles on the base material 1 (on at least one surface of the base material 1).

Here, the conductive composition contains conductive particles (A) containing at least one element selected from the group consisting of copper and silver, and a compound (B) that suppresses one or both of corrosion and aggregation of the conductive particles (A).

Through their own studies, the present inventors have considered that, in a case where a conductive film is formed by a method in the conventional art, (i) the oxide film present on the surface of the conductive particles may hinder the formation of a conductive film having high conductivity, or (ii) the unintended aggregation of the conductive particles may hinder the formation of a conductive film having high conductivity.

Based on this idea, the present inventors have determined to use, as the conductive particles contained in the conductive composition, a "conductive particles containing at least any one element selected from the group consisting of copper and silver" (conductive particles (A)) having high conductivity and suitable for forming a conductive film by pressing and a compound (B) that suppresses one or both of corrosion and aggregation of the conductive particles (A) together. In addition, by providing a conductive film at least by pressing using the conductive composition including the conductive particles (A) and the compound (B), the conductivity of the conductive film could be improved.

Incidentally, in the conductive film formation step, in a case where the compound (B) is present on the surface of the conductive particles (A) or in the vicinity of the surface of the conductive particles (A), it is also thought that the metal bond between the conductive particles (A) is hindered. However, according to the findings of the present inventors, probably, at least a part of the compound (B) present on the surface of the conductive particles (A) or in the vicinity of the surface "separates" from the surface of the conductive particles (A) or in the vicinity of the surface due to the pressing force in the conductive film formation step. Therefore, it is considered that even in a case where the compound (B) is present on the surface of the conductive particles (A) or in the vicinity of the surface of the conductive particles (A), the conductive particles (A) can be bonded to each other, and a conductive film having good conductivity can be obtained.

Hereinafter, the film formation step will be described in more detail.

### ▪ Particle Diameter Distribution of Conductive Particles (A)

In a volume-based cumulative particle diameter distribution curve obtained in a case where a particle diameter of the conductive particles (A) is measured by a laser diffraction scattering method, a particle diameter (median diameter) at which a cumulative frequency is 50% is defined as D₅₀, a particle diameter at which a cumulative frequency is 10% is defined as D₁₀, and a particle diameter at which a cumulative frequency is 90% is defined as D₉₀.

D₅₀ is preferably 0.6 µm to 30 µm, more preferably 0.7 µm to 20 µm, and even more preferably 0.7 µm to 15 µm. By using the conductive particles (A) having a moderate median diameter, a balance between the ease of integration of particles with each other and the reduction of resistance due to the decrease in the number of boundaries between particles in a case where pressure is applied is improved, and thus the conductivity of the obtained conductive film can be further improved.

In addition, (D₉₀ - D₅₀)/D₅₀ is preferably 0.55 to 3.0, more preferably 0.55 to 2.5, and still more preferably 0.55 to 2.0. The value of (D₉₀ - D₅₀) /D₅₀ being 3.0 or less means that D₉₀ is relatively small with respect to D₅₀ and coarse particles are relatively few. In a case where the ratio of coarse particles in the conductive particles (A) is small, "gaps" between the conductive particles (A) are less likely to occur, and it is possible to expect further improvement in the conductivity of the conductive film. Incidentally, 0.6, which is the lower limit value, is a value set in consideration of the particle diameter distribution of conductive particles that are easily available industrially.

Further, (D₅₀ - D₁₀)/D₅₀ is preferably 0.4 to 0.8, more preferably 0.4 to 0.7, and still more preferably 0.5 to 0.7. In order to improve the conductivity of the conductive film obtained by at least pressing the film containing the conductive particles (A), it is preferable to increase the density of the conductive particles (A) in the film. It is considered that a method for this purpose is to adjust and optimize the particle diameter distribution of the conductive particles (A) such that an appropriate amount of particles having relatively small particle diameters are present in the "gaps" between particles having relatively large diameters. (D₅₀ - D₁₀)/D₅₀ can be interpreted to correspond to the fact that an appropriate amount of particles having a particle diameter relatively smaller than that of particles having a particle diameter in the vicinity of D₅₀ is present in the conductive particles (A).

In addition, it is also considered that the inclusion of a "certain amount" of sub-micron-sized conductive particles (A) has a certain sintering promotion effect.

In a case where certain conductive particles (A) are purchased products and a volume-based cumulative particle diameter distribution curve of the conductive particles (A) is provided from a purchase source, the values of D₅₀ and the like of the conductive particles (A) may be obtained based on the curve. When the values of D₅₀ and the like are provided by the supplier, it is possible to adopt the provided values.

Meanwhile, when it is not possible to know the values of D₅₀ and the like as described above, the conductive particles (A) are measured for particle diameter by the laser diffraction scattering method to obtain the volume-based cumulative particle diameter distribution curve. Measurements are usually performed using a wet method. In this case, examples of the dispersion medium include water and isopropanol containing a surfactant (an appropriate dispersion medium can be selected in consideration of the state of the surface treatment agent of the conductive particles (A), and the like). Examples of measuring devices include the SALD series (SALD-2300 or the like) from Shimadzu Corporation. When using the SALD series as a device, it is preferable to measure the particle diameter while circulating the dispersion medium while generating ultrasonic waves using the attached ultrasonic unit.

### ▪ Chemical Composition of Conductive Particles (A)

As described above, the conductive particles (A) preferably contain at least any one element selected from the group consisting of silver and copper.

Specifically, the conductive particles (A) preferably include at least one selected from the group consisting of particles mainly composed of silver and particles mainly composed of copper. Here, the expression "mainly composed of silver" means that the ratio of the silver element to all constituent elements in the particles is preferably 50 mol% or more, more preferably 75 mol% or more, even more preferably 90 mol% or more, and particularly preferably 95 mol% or more. Similarly, the expression "mainly composed of copper" means that the ratio of the copper element to all constituent elements in the particles is preferably 50 mol% or more, more preferably 75 mol% or more, even more preferably 90 mol% or more, and particularly preferably 95 mol% or more.

For the sake of completeness, the conductive particles (A) may contain or may not substantially contain elements other than silver and copper, as long as desired conductivity is obtained. Examples of elements other than silver and copper include gold, aluminum, platinum, palladium, iridium, tungsten, nickel, tantalum, lead, zinc, and the like. Here, "substantially does not contain" means that the ratio of elements other than silver and copper in the conductive particles (A) is, for example, 1% by mass or less, specifically 0.5% by mass or less, and more specifically 0.1% by mass or less.

The conductive particles (A) may contain only one element or may contain two or more elements. For example, conductive particles in which the surface of copper particles is silver-plated (silver-coated copper particles) and the like are preferably used in the present embodiment. Silver-coated copper particles are particles mainly composed of copper for which the surface of the copper particles is plated with silver in an amount of up to a maximum of 35% by mass based on the total mass of the particles, for example.

### ▪ Method for Obtaining Conductive Particles (A)

It is possible to purchase conductive particles (A) that are usable in the present embodiment from, for example, Dowa Electronics Materials Co., Ltd., Fukuda Metal Foil and Powder Co., Ltd., and the like.

Incidentally, in order to adjust and optimize the particle diameter distribution, two or more different conductive particles (A) may be mixed and used.

### ▪ Ratio of Conductive Particles (A) in Conductive Composition

From the viewpoint of further reducing the specific resistance of the conductive film, the ratio of conductive particles (A) in the conductive composition is preferably large. Specifically, the ratio of the conductive particles (A) in the all non-volatile components of the conductive composition is preferably 95% by mass or more, more preferably 97% by mass or more, even more preferably 98% by mass or more, and particularly preferably 99% by mass or more.

### ▪ Compound (B)

As the compound (B), a compound having a function of suppressing one or both of corrosion and aggregation of the conductive particles (A) can be used without particular limitation.

As an example of the preferred compound (B), a ligand (B1) capable of coordinating to copper or silver in the conductive particles (A) can be mentioned. In a case where the ligand (B1) is coordinated to copper or silver in the conductive particles (A), oxidation of the surface of the conductive particles (A) can be suppressed. In this manner, the conductivity of the conductive film to be formed can be further increased.

In the conductive film formation step described later, it is considered that at least a part of the ligand (B1) coordinated to the conductive particles (A) is desorbed from the surface of the conductive particles (A) by the action of pressure, and a "non-oxidized portion" is formed on the surface of the conductive particles (A). It is considered that a conductive film having high conductivity is formed by bonding the "non-oxidized portions" to each other.

As the ligand (B1), one or more compounds preferably selected from the group consisting of an amine, an imine, a phosphine, an azole, and a carboxylic acid can be mentioned.

Specific examples of the amine include 2-{[(2-dimethylamino)ethyl]methylamino}ethanol, 1,2-propanediamine, 1,2-cyclohexanediamine, monoethanolamine, diethanolamine, and triethanolamine.

Specific examples of the imine include diimine, ethyleneimine, propyleneimine, hexamethylenimine, benzophenoneimine, and methyl ethyl ketoneimine.

Specific examples of the phosphine include phosphinic acid and various compounds known as phosphine ligands in the field of organometallic chemistry. The phosphine ligand is represented by, for example, a general formula PRR'R". In the general formula, R, R', and R" are each independently a hydrogen atom or a monovalent organic group, and examples of the monovalent organic group include an alkyl group and an aryl group.

Specific examples of the azole include triazole, tetrazole, benzotriazole, tolyltriazole, aminotriazole, aminobenzimidazole, pyrazole, imidazole, aminotetrazole, and derivatives thereof.

Specific examples of the carboxylic acid include adipic acid, gluconic acid, lactic acid, citric acid, tartaric acid, malic acid, glycolic acid, malonic acid, acetic acid, propionic acid, succinic acid, and derivatives thereof.

Of course, a compound that is capable of coordinating to the conductive particles (A) can be used as the ligand (B1) without particular limitation even in a case where the compound is other than the above-described compounds.

As the ligand (B1), at least any one selected from the group consisting of a monodentate ligand and a bidentate ligand is particularly preferable.

As described above, in the conductive film formation step described later, it is considered that at least a part of the ligand (B1) coordinated to the conductive particles (A) is desorbed from the conductive particles (A) by the action of pressure, and a portion of the conductive particles (A) is "not oxidized or slightly oxidized" on the surface. In addition, it is considered that the "portion that is not oxidized or is slightly oxidized" are bonded to each other by pressure to form a conductive film having high conductivity. It is considered that the monodentate ligand and the bidentate ligand are easily desorbed from the surface of the conductive particles (A) during pressing in the conductive film formation step because the interaction with the conductive particles (A) is not too strong. Therefore, it is considered that the surfaces of the conductive particles (A) that are not oxidized are more likely to come into contact with each other. It is considered that, by using a monodentate ligand or a bidentate ligand as the ligand (B1) by such a mechanism, the conductivity of the conductive film can be further increased, or the conductive particles (A) can be sufficiently bonded to each other even in a case where the pressing force is relatively low.

Specific examples of the monodentate ligand and the bidentate ligand include those corresponding to the monodentate ligand or the bidentate ligand from the examples described above as the ligand (B1).

Incidentally, in the coordination involving π electrons, it is determined whether a certain ligand is a monodentate ligand or a polydentate ligand based on the "hapticity". That is, the ligand having a hapto number of 1 is classified as a monodentate ligand. In addition, the ligand having a hapticity of 3 is classified as a tridentate ligand which is a kind of a polydentate ligand.

Another example of the compound (B) includes a reducing agent (B2). It is considered that, due to the action of the reducing agent (B2), at least a part of the surface of the conductive particles (A) is not oxidized or is a portion where the oxidation is slight.

The reducing agent (B2) can be ascorbic acid, oxalic acid, formic acid, or the like. Here, the carboxylic acid having reducing properties is classified as the reducing agent (B2) instead of the ligand (B1).

In addition, specific examples of the reducing agent also include hydrazine, a hydrazine hydrate, sodium, carbon, potassium iodide, iron(II) sulfide, sodium thiosulfate, tin(II) chloride, diisobutylaluminum hydride, sodium borohydride, and sulfite.

Another example of the compound (B) includes a nitrile compound (B3), that is, a compound having a nitrile group. It is presumed that the nitrile compound (B3) adsorbs to the surface of the conductive particles (A) in the nitrile group portion to suppress the oxidation of the conductive particles (A).

Examples of the nitrile compound (B3) include various organic compounds having a nitrile group. Specifically, alkanenitrile is preferable. The number of carbon atoms in the alkanenitrile can be, for example, 1 to 20.

From another viewpoint, the boiling point of the nitrile compound (B3) such as alkanenitrile at normal pressure is preferably 340°C or lower. It is considered that the nitrile compound (B3) having a low boiling point is likely to be separated from the surface of the conductive particles (A) or the vicinity thereof due to the pressure in the conductive film formation step. Then, it is considered that this makes it possible to obtain a conductive film having further improved conductivity.

Another example of the compound (B) includes a dispersant (B4). By using the dispersant (B4), it is possible to suppress unintentional aggregation of the conductive particles (A) before carrying out the conductive film formation step. As a result, it is considered that, in the conductive film formation step, the "gap" between the conductive particles (A) can be reduced, and thus the conductivity of the obtained conductive film can be further increased.

Examples of the dispersant (B4) include a polyolefin-based resin, a polyvinyl alcohol-based resin, a polyalkylene glycol-based resin, a polyvinylpyrrolidone-based resin, a polyester-based resin, a polyamide-based resin, an acrylic resin, a urethane-based resin, and an epoxy-based resin.

In addition, as the dispersant (B4), a dispersant that can function as a dispersant may be selected and used from known surfactants.

The conductive composition may contain only one compound (B) or may contain two or more compounds (B). By using two or more different kinds of compounds (B), a certain synergistic action or complementary action may work, and the oxidation suppressing effect on the surface of the conductive particles (A) may be further enhanced, and as a result, the conductivity of the obtained conductive film may be further enhanced. For example, a combination of the nitrile compound (B3) and the ligand (B1) and/or the reducing agent (B2) is mentioned as a preferred aspect.

By optimizing the amount of the compound (B) used, the conductivity of the finally obtained conductive film can be further increased. By using a large amount of the compound (B) to some extent, oxidation of the surface of the conductive particles (A) can be sufficiently suppressed, or aggregation of the conductive particles (A) can be sufficiently suppressed. On the other hand, in a case where the amount of the compound (B) is not too large, the ratio of the "conductive component" (copper or silver) in the conductive composition is increased, and thus the conductivity of the finally obtained conductive film can be further increased. In addition, in the conductive film formation step, a portion where the oxidation is not performed or is slightly oxidized on the surface of the conductive particles (A) is easily exposed, and thus the conductivity of the finally obtained conductive film can be further increased.

Specifically, the amount of the compound (B) (the total amount in a case where two or more compounds (B) are used) is preferably 0.01 to 10 parts by mass and more preferably 0.03 to 5 parts by mass with respect to 100 parts by mass of the conductive particles (A).

### ▪ Other Components

The conductive composition may contain components other than the conductive particles (A) and the compound (B).

It is possible for the conductive composition to include a solvent. In a case where the conductive composition contains a solvent, the film forming property of the conductive composition on the base material is improved. The solvent typically includes an organic solvent.

The type of solvent is not particularly limited. The solvent may be any solvent that does not substantially alter each of the components in the conductive composition.

The amount of the solvent used may be appropriately adjusted according to the applying and printing method of the conductive composition and the like. The usage amount of the solvent is, for example, 3 to 35% by mass in the entire conductive composition, preferably 5 to 30% by mass, and more preferably 10 to 30% by mass.

From the viewpoint of the adhesion to the base material 1, the film forming property, the printability, and the like, the conductive composition may or may not include a binder.

When a binder is used, the type of binder is not particularly limited, but preferable examples thereof include polyvinylpyrrolidone, polyester, epoxy resin, (meth)acrylic resin, polyvinyl acetal, cellulose resin (for example, ethyl cellulose, and the like), phenol resin, and the like.

From the viewpoint of maintaining the conductivity of the conductive film, the amount of binder in the all non-volatile components of the conductive composition is preferably 5% by mass or less, more preferably 3% by mass or less, even more preferably 2% by mass or less, and particularly preferably 1% by mass or less. The lower limit of the amount of binder may be 0. However, when it is intended to actively obtain effects such as improved adhesion by using a binder, the amount of binder is preferably 1% by mass in the all non-volatile components of the conductive composition and more preferably 2% by mass or more. That is, from the viewpoint of the balance of various performances, the amount of the binder is preferably 1 to 5% by mass in the all non-volatile components of the conductive composition and more preferably 2 to 5% by mass.

The conductive composition may or may not include various other additive components in conventional ink compositions and conductive pastes.

### ▪ Base Material 1

The base material 1 is usually in the form of a film, sheet, or plate. From the viewpoint of industrial productivity, the shape of the base material 1 is preferably one of the above.

The base material 1 is preferably flexible. By adopting the base material 1 having flexibility, it is possible to produce a flexible printed circuit board (FPC).

In addition, the base material 1 having flexibility has the advantage that the conductive film is easily formed by the roll press step in the conductive film formation step described below.

To be clear, the base material 1 may be a rigid base material that does not have flexibility.

In consideration of cost and the final use, the base material 1 is preferably at least one selected from the group consisting of polyesters such as polyethylene terephthalate (PET) and polyethylene naphthalate (PEN), polyolefins such as polyethylene and polypropylene, polyimide, and paper. Here, the paper may be coated paper (paper for which the surface is coated with a coating agent) or ordinary paper that is not coated paper. In addition, the base material 1 is not limited to PET or the like and it is possible to adopt a general resin film.

As described below, in the present embodiment, it is possible to obtain a conductive film having a sufficiently low specific resistance without heating or by heating at a relatively low temperature in the conductive film formation step. Therefore, it is also possible to suitably use the base material 1 having low heat resistance such as polyester, polyolefin, and paper, as the base material. In addition, when the base material 1 having high heat resistance such as polyimide is used, it is possible to further reduce the specific resistance by performing high-temperature heating in the conductive film formation step.

### ▪ Film Forming Method

A film forming method for the conductive composition is not particularly limited.

The conductive composition may form a film on the entire surface of one surface of the base material, or may form a film only on a part of one surface of the base material. In the former case, it is possible to perform the film formation (coating) using a device such as a blade coater, an air knife coater, a doctor coater, a roll coater, a bar coater (rod coater), or a curtain coater. In the latter case, it is possible to apply various printing methods, for example, screenprinting methods, gravure printing methods, letterpress printing methods, lithographic printing methods (offset printing methods), ink jet printing methods, and the like. By appropriately designing the "pattern" of the film formation, it is possible to produce a base material provided with a pattern structure, such as a conductive film (circuit pattern) able to function as a circuit or a mesh pattern that has an electromagnetic shielding ability. In a case where the conductive composition forms a film only on a part of one surface of the base material, it is preferable that the "pattern" of the film formation is appropriately designed according to the application of the finally obtained conductive film.

To prevent the conductive composition from being film-formed on places other than the desired places, for example, a step may be performed in which a film with holes cut out is placed on the base material 1, the conductive composition is film-formed from above, and then the film is removed.

From the viewpoint of obtaining sufficient conductivity when made into a conductive film and the viewpoint of ease of film formation, the thickness (dry thickness when the conductive composition includes a solvent) of the film 3 is preferably 5 µm to 100 µm and more preferably 10 µm to 50 µm.

In particular, when the conductive composition includes a solvent, it is preferable to perform a heat treatment to dry the solvent. The conditions of the heat treatment are not particularly limited as long as the solvent is sufficiently dried, but from the viewpoint of sufficient drying of the solvent and suppression of alteration of the conductive particles due to excessive heating, the heat treatment temperature is preferably 50°C to 150°C and more preferably 80°C to 120°C. The heat treatment time is preferably 1 to 60 minutes and more preferably 3 to 30 minutes.

Specifically, it is possible to perform the heat treatment for drying the solvent by blowing hot air on the film 3. Naturally, the heat treatment may be performed by other methods.

### (FIG. 2: Conductive Film Formation Step)

In the conductive film formation step, the film 3 is pressed at least to form a conductive film. FIG. 2 schematically shows a case where a roll press is adopted as the pressing means.

When a roll press is adopted as the pressing means, the base material 1 provided with the film 3 is sandwiched between two opposing rolls 10A and 10B in the conductive film formation step. The sandwiched base material 1 is transported from the left to the right in FIG. 2 by the force of the rotation (indicated by the arrows in FIG. 2) of the rolls 10A and 10B or the like.

In the roll press step, a pressure of 10 MPa or more is preferably applied to the base material 1 provided with the film 3. This pressure is more preferably 10 to 5000 MPa, even more preferably 20 to 300 MPa, and particularly preferably 30 to 250 MPa. By applying a pressure of 10 MPa or more, it is possible to further reduce the specific resistance of the obtained conductive film. In addition, since the pressure is 5000 MPa or less, damage to the base material 1 or the film 3 can be suppressed. Incidentally, when the base material 1 has sufficient strength, it is possible to further reduce the specific resistance of the conductive film by increasing the pressure.

In the conductive film formation step, it is preferable to press the film 3 while heating the film 3.

When the film 3 is heated, the heating temperature may be set appropriately according to the heat resistance of the base material 1, the type of conductive particles to be used, and the like. For example, when the base material 1 is formed of a low heat-resistant material such as polyester, polyolefin, or paper, it is preferable to set the heating temperature in the range of, for example, 50°C to 200°C, more preferably 70°C to 180°C, even more preferably 70°C to 150°C, and particularly preferably 80°C to 125°C, taking into consideration the heat resistance temperature of the base material to be used, such that the base material does not substantially soften, melt, or the like. However, in a case where the heating time is short, heating at a higher temperature (for example, 400°C) may be allowed.

On the other hand, when the base material 1 is formed of a highly heat-resistant material such as polyimide, it is possible to set the heating temperature to 50°C to 400°C. That is, in a case of heating the film 3, the temperature is preferably appropriately adjusted to 400°C or lower.

It is also possible to appropriately set the heating time depending on the heat resistance of the base material 1, the type of conductive particles to be used, and the like. The heating time is, for example, 0.01 to 1 second and preferably 0.04 to 0.6 seconds. Incidentally, when a roll press is adopted in the conductive film formation step, the "heating time" refers to the time during which the film 3 is heated while being in contact with the rolls and pressed. As an example, when the contact width between two opposing rotating rolls is 1 mm and the speed at which the base material passes between the two rolls is v, the heating time (equal to the pressing time) is 0.59 seconds when v = 0.1 m/min, 0.04 seconds when v = 1.5 m/min, 0.06 seconds when v = 1.0 m/min, and 0.012 seconds when v = 5.0 m/min.

In a case where the roll pressing is adopted in the conductive film formation step, since the film 3 is pressed while being heated, it is preferable that at least the roll 10A on the side close to the film 3 among the two rolls is heated. As explained above, it is possible to appropriately set the heating temperature of the roll 10A at 400°C or lower depending on the heat resistance of the base material 1, the type of conductive particles to be used, and the like. In addition, it is possible to adjust the heating time by changing the rotation speed (that is, the transport speed) of the roll 10A and the roll 10B. The transport speed may be appropriately adjusted between 0.1 to 10 m/min, for example, while taking into consideration the securing of sufficient heating and pressing time, mass productivity, and the like.

In addition, to achieve uniform heating and shorten the heating time, not only the roll 10A but also the roll 10B may be heated.

On the other hand, as long as it is possible to obtain a conductive film having a sufficiently low specific resistance, the roll 10A may not be heated and the roll 10B also may not be heated.

Incidentally, in a case where a conductive film having a sufficiently small specific resistance can be obtained, the film 3 may not be heated in the conductive film formation step. Specifically, when the conductive film formation step includes a roll press step, the roll 10A may not be heated and the roll 10B also may not be heated. In particular, when particles mainly composed of silver are used as the conductive particles, it is possible to easily obtain a conductive film having a sufficiently low specific resistance by pressing alone.

Although not shown in FIG. 2, in the roll press step, for example, the rolls 10A and 10B may be rotated while a resin film is sandwiched between the film 3 and the roll 10A. By interposing the resin film between the film 3 and the roll 10A, it is possible to suppress the film 3 from being peeled off and attached to the roll 10A. In addition, since the resin film is interposed between the film 3 and the roll 10A, the pressure applied to the film 3 is appropriately dispersed, and thus, there is a tendency that a conductive film having more homogeneous and constant performance is easily obtained.

The material of the resin film sandwiched between the film 3 and the roll 10A is not particularly limited. In terms of heat resistance and durability, it is possible to preferably use a polyimide film or the like.

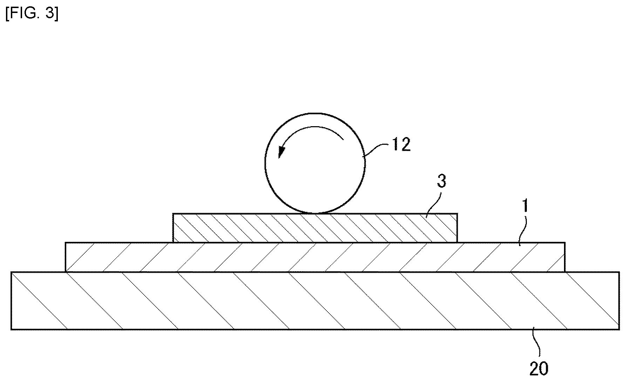

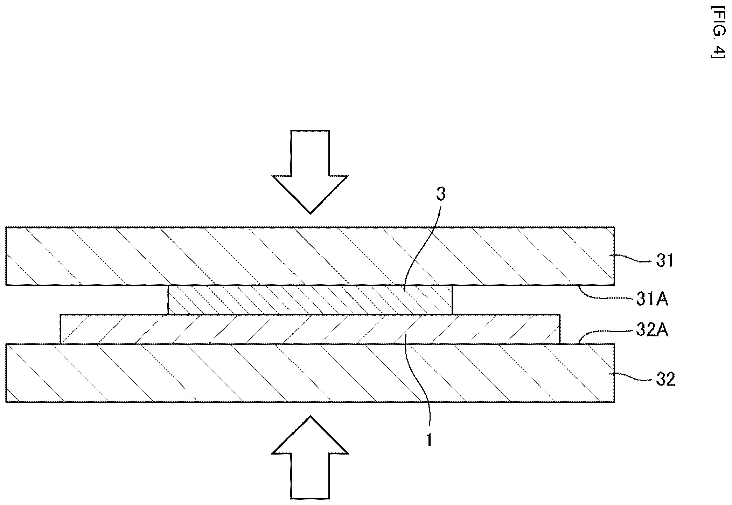

### (FIGS. 3 and 4: Modification Example of Conductive Film Formation Step)

To be clear, the roll press step has been explained above as a specific method for the conductive film formation step, but as long as it is possible to apply sufficient pressure (and heat in some cases) to the film 3, the conductive film formation step may be performed by a method other than roll press. However, considering ease of mass production, the conductive film formation step preferably includes a roll press step.

To be clear, an explanation will be given below of steps other than the roll press step that are applicable to the conductive film formation step.

As shown in FIG. 3, the conductive film formation step may include a step of placing the base material 1 provided with the film 3 on a flat surface 20A of a table 20 having a flat surface and pressing the film 3 at least from above using a roll 12. As long as it is possible to apply appropriate pressure, the table 20 having a flat surface may be a flat plate instead of a table. The main point is that the base material 1 is placed on a flat surface and it is possible to carry out the pressing appropriately using the roll 12.

As shown in FIG. 4, the conductive film formation step may include a step in which the base material 1 provided with the film 3 is sandwiched between a first flat surface 31A of a first pressing member 31 having the first flat surface 31A and a second flat surface 32A of a second pressing member 32 having the second flat surface 32A. An example of a device preferably used for carrying out such a step is the pressing device "CYPF-400" manufactured by Shintokogio, Ltd., or the like.

### <Method for Producing Electronic Device>

It is possible to produce an electronic device using the conductive base material obtained through the above film formation step and conductive film formation step. For example, by appropriately designing the "pattern" of the coating or the printing in the film formation step, it is possible to produce a base material provided with a conductive film (circuit pattern) able to function as a circuit, as well as to produce an electronic device by combining this base material with other electronic elements.

Here, a description will be given of some examples of "electronic devices", but the electronic devices including the conductive base material obtained by the method for producing a conductive base material of the present embodiment are naturally not limited only thereto.
▪ Sensor: For example, it is possible to apply the conductive base material obtained by the method for producing a conductive base material of the present embodiment in a conductive member/circuit in a sensor such as a pressure sensor or a vital sensor.
▪ Solar cell: For example, it is possible to apply the conductive base material obtained by the method for producing a conductive base material of the present embodiment in the current collector wiring of a solar cell.
▪ Membrane switch: A membrane switch is a thin planar switch in which a circuit and contacts are printed on a film and then laminated. It is possible to apply the method for producing a conductive base material of the present embodiment to form the circuit and contacts.
▪ Touch sensor and touch panel: For example, it is possible to apply the method for producing a conductive base material of the present embodiment to form the lead-out wiring in a touch sensor and touch panel. In addition, it is also conceivable to apply the method for producing a conductive base material of the present embodiment to form transparent electrodes in a touch sensor and touch panel.
▪ Flexible base material: Conventionally, a circuit is formed by first coating the entire surface of a flexible film with a metal film and then removing unnecessary parts of the metal film using a chemical agent. Instead of such conventional method, it is conceivable to form a circuit by the method for producing a conductive base material of the present embodiment.

In particular, in conventional electronic devices in which circuits are formed using conductive paste, it is possible to expect that using the method for producing a conductive base material of the present embodiment for forming a circuit will reduce the specific resistance of the circuit and improve the performance of the electronic device.

Examples of particularly preferable electronic devices include an RF tag. That is, the method for producing a conductive base material of the present embodiment is preferably used to produce a conductive circuit such as an antenna part in an RF tag.

For the specific structure of an RF tag, for example, it is possible to refer to Japanese Unexamined Patent Publication No. 2003-332714, Japanese Unexamined Patent Publication No. 2020-46834, and the like.

### <Method for Producing Electromagnetic wave shielding film>

As an application other than electronic devices, it is conceivable to produce an electromagnetic wave shielding film by the method for producing a conductive base material of the present embodiment. Specifically, in the film formation step, it is possible to produce an electromagnetic wave shielding film by setting the pattern when film-forming the conductive composition to be a pattern specific to an electromagnetic wave shielding film (a mesh pattern or the like).

### <Method for Producing Planar Heating Element>

As yet another application, it is conceivable to produce a planar heating element using the method for producing a conductive base material of the present embodiment. A planar heating element generates heat by passing electric current through electrical wiring provided on a base material. Specific examples of planar heating elements include planar heating elements for preventing fogging and protection against cold, such as the rear glass of a passenger vehicle or the like.

### <Conductive Composition>

Above, the embodiments of the present invention were explained with a focus on the "methods" of the method for producing a conductive base material and the method for producing an electronic device. Apart from this, it is also possible to regard the embodiments of the present invention as conductive compositions.

That is, the following conductive composition is preferably used to form a conductive film having a low specific resistance.

"A conductive composition containing conductive particles, which is used for a use application of forming a film on a base material and forming a conductive film by at least pressing the film,
the conductive composition containing: conductive particles (A) containing at least any one element selected from the group consisting of copper and silver; and a compound (B) that suppresses one or both of corrosion and aggregation of the conductive particles (A)."

Specific forms of the composition were explained in the section <Method for Producing Conductive Base Material>. Therefore, the explanation will not be repeated.

As described above, the embodiments according to the present invention have been described; however, these are examples according to the present invention, and thus it is possible to adopt various configurations other than the above. In addition, the present invention is not limited to the embodiments described above and modifications, improvements, and the like are included in the present invention in a range in which it is possible to achieve the object of the present invention.

### Examples

A detailed description will be given of embodiments of the present invention based on Examples and Comparative Examples. It should be noted that the present invention is not limited to Examples only.

In the following, exponential notation may be indicated by the symbol "E". For example, 1.3. E-06 means 1.3 x 10⁻⁶.

### <Preparation of Conductive Composition>

The components shown in Table 1 below were stirred using a planetary stirrer. As a result, a uniform paste-like conductive composition was obtained. In Table 1, the unit of the amount of each component is part by mass.

The information on some components in Table 1 will be supplemented.
Copper particles 1: median diameter 10.3 µm
Silver particles 1: median diameter 6.1 µm
Alkanenitrile: mixture of several kinds of alkanenitriles having the number of carbon atoms in a range of 1 to 18 (boiling point: 340°C or lower)

### (Film Formation Step and Conductive Film Formation Step)

A film formation step and a conductive film formation step were carried out according to the following procedure to produce a conductive base material provided with a conductive film.
(1) A coating film (solid film) with a size of 15 mm x 5 mm was formed on the base material using the conductive composition. Specifically, first, 3M Scotch tape was stuck to the base material to create a "cut-out area" with a size of 15 mm x 5 mm. Then, a squeegee was used to squeegee the conductive composition on the cut-out area, filling the cut-out area with the conductive composition. The Scotch tape was then removed. The thickness of the coating film at this time was approximately 40 µm.
   A polyimide film was used as the base material.
(2) The base material provided with the coating film was placed in a hot air circulating atmospheric oven and heated at 100°C for 15 minutes. This allowed the solvent to dry.
(3) The coating film from which the solvent had dried was roll pressed together with the base material using a load-adjustable roll press machine (manufactured by Tester Sangyo Co., Ltd., the general structure of which is schematically shown in FIG. 2) under the following conditions:
   ▪ Temperature of roll 10A: heated to 200°C
   ▪ Pressure: 121 MPa
   ▪ Transport speed: 0.1 m/min

Incidentally, the pressure described above was calculated using the following calculation.
▪ Based on a roll width of 165 mm and a contact width between rolls of 1 mm, the area to which pressure was applied was 165 mm².
▪ The pressing was 20 kN.
▪ Since a force of 20 kN was applied to a region of 165 mm², the pressure was calculated as 121 MPa by calculating 20 kN/165 mm².

### (Measurement of Specific Resistance)

The resistance value of the conductive film obtained above was measured using a four-terminal resistance meter and the film thickness was measured using a film thickness gauge. The specific resistance was calculated from the measured resistance value and film thickness.

Table 1 shows the composition information and the evaluation results of the conductive composition.

### [Table 1]

**Table 1**

| | | | Example 1 | Example 2 | Example 3 | Example 4 | Example 5 | Example 6 | Example 7 | Example 8 | Example 9 | Example 10 | Example 11 | Comparative Example |
|---|---|---|---|---|---|---|---|---|---|---|---|---|---|---|
| Conductive particles (A) | | Copper particles 1 | 75 | | 75 | 75 | 75 | 75 | 75 | 75 | 75 | 75 | 75 | 75 |
| | | Silver particles 1 | | 75 | | | | | | | | | | |
| Compound (B) | Ligand (B1) | Triethanolamine | | | 1 | 3 | 5 | | | | | | | |
| | | Phosphinic acid | | | | | | 0.5 | | | | | | |
| | | Adipic acid | | | | | | | 0.5 | | | | | |
| | Reducing agent (B2) | Ascorbic acid | | | | | | | | 0.5 | 1 | 3 | 5 | |
| | Nitrile compound (B3) | Alkanenitrile | 0.4 | 0.4 | 0.4 | 0.4 | 0.4 | 0.4 | 0.4 | 0.4 | 0.4 | 0.4 | 0.4 | |
| Organic solvent | | | 25 | 25 | 24 | 22 | 20 | 24.5 | 24.5 | 24.5 | 24 | 22 | 20 | 25 |
| Specific resistance (Ω 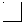 cm) | | | 6.3.E-06 | 2.8.E-06 | 5.6.E-06 | 5.5.E-06 | 5.5.E-06 | 5.7.E-06 | 5.7.E-06 | 4.9.E-06 | 5.2.E-06 | 5.2.E-06 | 5.1.E-06 | 0.01 or more |

As shown in Table 1, a conductive base material having a conductive film with good conductivity can be produced by forming a film on a base material using a conductive composition including conductive particles (A) containing at least any one element selected from the group consisting of copper and silver and a compound (B) that suppresses one or both of corrosion and aggregation of the conductive particles (A), and applying pressure to the film.

Analyzing the Examples in more detail, in the example using the same copper particles 1 in which the nitrile compound (B3), the ligand (B1), and/or the reducing agent (B2) were used in combination as the compound (B), the specific resistances of Examples 3 to 11 were smaller than the specific resistance of Example 1 in which only the nitrile compound (B3) was used as the compound (B). From this, it is understood that the conductivity of the obtained conductive film can be further enhanced by using two or more different kinds of compounds (B).

This application claims priority based on Japanese Patent Application No. 2023-054831 filed on March 30, 2023, the entire disclosure of which is incorporated herein by reference.

### REFERENCE SIGNS LIST

- 1: base material
- 3: film
- 10A: roll
- 10B: roll
- 12: roll
- 20: table having a flat surface
- 20A: flat surface
- 31: first pressing member
- 31A: first flat surface
- 32: second pressing member
- 32A: second flat surface

## Claims

1. A method for producing a conductive base material, the method comprising:
a film formation step of providing a film formed of a conductive composition over a base material; and
a conductive film formation step of forming a conductive film by at least pressing the film,
wherein the conductive composition contains
conductive particles (A) containing at least one element selected from the group consisting of copper and silver, and
a compound (B) that suppresses one or both of corrosion and aggregation of the conductive particles (A).

2. The method for producing a conductive base material according to Claim 1,
wherein the base material is flexible.

3. The method for producing a conductive base material according to Claim 1 or 2,
wherein, in the conductive film formation step, the film is pressed while being heated.

4. The method for producing a conductive base material according to Claim 1 or 2,
wherein the compound (B) includes a ligand (B1) that is capable of coordinating to copper or silver in the conductive particles (A).

5. The method for producing a conductive base material according to Claim 4,
wherein the ligand (B1) includes one or more compounds selected from the group consisting of an amine, an imine, a phosphine, an azole, and a carboxylic acid.

6. The method for producing a conductive base material according to Claim 4,
wherein the ligand (B1) includes at least one selected from the group consisting of a monodentate ligand and a bidentate ligand.

7. The method for producing a conductive base material according to Claim 1 or 2,
wherein the compound (B) includes a reducing agent (B2).

8. The method for producing a conductive base material according to Claim 7,
wherein the reducing agent (B2) includes at least one selected from the group consisting of ascorbic acid, oxalic acid, and formic acid.

9. The method for producing a conductive base material according to Claim 1 or 2,
wherein the compound (B) includes a nitrile compound (B3).

10. The method for producing a conductive base material according to Claim 1 or 2,
wherein in a volume-based cumulative particle diameter distribution curve obtained in a case where the conductive particles (A) are subjected to particle diameter measurement by a laser diffraction scattering method, a particle diameter D₅₀ at which a cumulative frequency is 50% is 0.6 to 50 µm.

11. The method for producing a conductive base material according to Claim 1 or 2,
wherein an amount of binder in all non-volatile components of the conductive composition is 5% by mass or less.

12. The method for producing a conductive base material according to Claim 1 or 2,
wherein the conductive film formation step includes a roll press step in which the base material provided with the film is transported between two opposing rolls.

13. The method for producing a conductive base material according to Claim 12,
wherein, in the roll press step, a roll of the two rolls with which the film comes into contact is not heated, or is heated to 400°C or lower.

14. The method for producing a conductive base material according to Claim 12,
wherein, in the roll press step, a pressure of 10 to 150 MPa is applied to the base material provided with the film.

15. The method for producing a conductive base material according to Claim 1 or 2,
wherein the conductive film has a pattern structure.

16. A method for producing an electronic device,
wherein an electronic device is produced using the conductive base material obtained by the method for producing a conductive base material according to Claim 1 or 2.

17. The method for producing an electronic device according to Claim 16,
wherein the electronic device is an RF tag.

18. A method for producing an electromagnetic wave shielding film,
wherein an electromagnetic wave shielding film is produced using the conductive base material obtained by the method for producing a conductive base material according to Claim 1 or 2.

19. A method for producing a planar heating element,
wherein a planar heating element is produced using the conductive base material obtained by the method for producing a conductive base material according to Claim 1 or 2.

20. A conductive composition that is used for application where a film is formed over a base material and a conductive film is formed by at least pressing the film and contains conductive particles, the conductive composition comprising:
conductive particles (A) containing at least one element selected from the group consisting of copper and silver; and
a compound (B) that suppresses one or both of corrosion and aggregation of the conductive particles (A).

21. The conductive composition according to Claim 20,
wherein the compound (B) includes a ligand (B1) that is capable of coordinating to copper or silver in the conductive particles (A).

22. The conductive composition according to Claim 21,
wherein the ligand (B1) includes one or more compounds selected from the group consisting of an amine, an imine, a phosphine, an azole, and a carboxylic acid.

23. The conductive composition according to Claim 21 or 22,
wherein the ligand (B1) includes at least one selected from the group consisting of a monodentate ligand and a bidentate ligand.

24. The conductive composition according to Claim 20 or 21,
wherein the compound (B) includes a reducing agent (B2).

25. The conductive composition according to Claim 24,
wherein the reducing agent (B2) includes at least one selected from the group consisting of ascorbic acid, oxalic acid, and formic acid.

26. The conductive composition according to Claim 20 or 21,
wherein the compound (B) includes a nitrile compound (B3).

27. The conductive composition according to Claim 20 or 21,
wherein in a volume-based cumulative particle diameter distribution curve obtained in a case where the conductive particles (A) are subjected to particle diameter measurement by a laser diffraction scattering method, a particle diameter D₅₀ at which a cumulative frequency is 50% is 0.6 to 50 µm.

28. The conductive composition according to Claim 20 or 21,
wherein an amount of binder in all non-volatile components is 5% by mass or less.
